# EUROPEAN PATENT APPLICATION

(11) **EP 4 633 313 A1**
(43) Date of publication of application: **15.10.2025**
(21) Application number: 25167271.3
(22) Date of filing: 31.03.2025
(51) Int. Cl.: H05K 7/20, F24F 9/00

(54) **AIR-BASED THERMAL SEPARATION SYSTEM**

(30) Priority: 02.04.2024 US 202418624748
(71) Applicant: Microsoft Technology Licensing, LLC, Redmond, WA 98052 (US)
(72) Inventor: BELL, Jr., Freddie,, Redmond, 98052 (US)
(74) Representative: CMS Cameron McKenna Nabarro Olswang LLP

(57) **Abstract**

An air-based thermal separation system for use proximate rack-mounted IT equipment including: an air circulation system configured to receive input air and generate an output airflow; and an air diffuser system configured to be longitudinally positioned within a hot aisle of a datacenter, the air diffuser system including: an input port for receiving the output airflow, and an essentially-linear discharge port for discharging the output airflow in a generally upward direction to form an essentially-planar discharge airflow.

## Description

### Technical Field

This disclosure relates to air distribution systems and, more particularly, to air distribution systems for use in the hot aisles of datacenters.

### Background

The history of cooling datacenters reflects the broader narrative of technological advancement and environmental awareness. In the initial stages of computer development, the heat generated by computers was relatively minimal, and simple, room-based air conditioning was often sufficient to maintain operational temperatures. However, as computers became more powerful and compact, and as datacenters started to house increasing numbers of servers, the heat generated became a significant issue, necessitating more sophisticated cooling solutions.

During the 1980s and 1990s, as the use of personal computers expanded and the internet began to take shape, datacenters grew in size and complexity. Cooling strategies evolved from simple air conditioning to more advanced computer room air conditioning (CRAC) units and computer room air handlers (CRAHs), designed specifically for datacenter environments. These systems focused on managing the airflow more efficiently, often employing raised floor systems to distribute cooled air directly to the servers.

The early 2000s marked a period of rapid growth in data processing and storage needs, driven by the dot-com boom, widespread adoption of the internet, and the beginning of cloud computing technologies. This period saw a significant increase in energy consumption by datacenters, making cooling efficiency a critical concern. Concepts such as hot aisle / cold aisle configurations, where racks are arranged to separate the hot exhaust air from the cool intake air, became standard practices to improve cooling efficiency and reduce energy consumption.

In recent years, the focus has shifted towards sustainable and energy-efficient cooling methods. Innovations such as using outside air (free cooling), especially in cooler climates or during colder months, and employing liquid cooling systems, where coolant is brought directly to the hot components, have gained popularity. These methods not only reduce energy consumption but also aim to minimize the environmental impact of datacenter operations. Additionally, the use of advanced management systems that utilize machine learning and artificial intelligence to optimize cooling based on real-time data has further enhanced efficiency.

Moreover, the industry has seen experimental and innovative approaches to datacenter cooling, including underwater datacenters, which leverage the natural cooling properties of water bodies, and building datacenters in cold locations like the Arctic. These approaches represent the cutting edge of cooling technology, showcasing the industry's ongoing efforts to balance computational demands with environmental sustainability and energy efficiency.

Overall, the history of cooling datacenters is a testament to the industry's adaptability and innovation, responding to the ever-increasing demands for data processing with creative and increasingly sustainable solutions.

### Summary

There is provided an air-based thermal separation system for use proximate rack-mounted IT equipment including: an air circulation system configured to receive input air and generate an output airflow; and an air diffuser system configured to be longitudinally positioned within a hot aisle of a datacenter, the air diffuser system including: an input port for receiving the output airflow, and an essentially-linear discharge port for discharging the output airflow in a generally upward direction to form an essentially planar discharge airflow.

### Brief Description of the Drawings

FIG. 1 is an isometric view of an air-based thermal separation system according to an embodiment of the present disclosure;
FIG. 2 is a front view of a computer rack assembly and rack-mounted IT equipment;
FIG. 3 is a top view of a datacenter;
FIG. 4 is a perspective view of a datacenter;
FIGS. 5-6 are perspective views of an air diffuser of the air-based thermal separation system of FIG 1 according to an embodiment of the present disclosure.

Like reference symbols in the various drawings indicate like elements.

### Detailed Description of the Preferred Embodiments

In a datacenter, hot aisle containment is a cooling strategy designed to optimize airflow management and cooling efficiency. This approach involves arranging server racks in alternating rows, forming cold aisles and hot aisles. The cold aisle is where servers draw in cool air, typically supplied through raised floor plenums or overhead ductwork, while the hot aisle is where servers expel hot exhaust air. Servers within the racks are oriented to either draw in cool air from the front and expel hot air from the back, or vice versa, depending on the specific layout.

Containment structures, such as doors, panels, or overhead ducts, are used to isolate the hot aisle and prevent hot air from mixing with the cool air in the cold aisle. Precision air conditioning units or computer room air conditioners (CRACs) supply the cold air to maintain optimal temperatures within the cold aisle. By containing the hot exhaust air and supplying cool air directly to the cold aisle, hot aisle containment improves cooling efficiency, reduces energy consumption, and enhances the performance and reliability of the IT equipment housed within the datacenter.

Unfortunately and oftentimes, the waste heat from a higher-power rack-mount IT component may exhaust upon (and heat up) lower-power rack mount IT components located across the hot aisle of the datacenter.

As will be discussed below in greater detail, implementations of the present disclosure are configured to utilize an air diffuser system that is longitudinally positioned within a hot aisle of a datacenter and configured to discharge output airflow in a generally upward direction to form an essentially-planar discharge airflow that thermally isolates opposite sides of the hot aisle of a datacenter.

### Air-based Thermal Separation System:

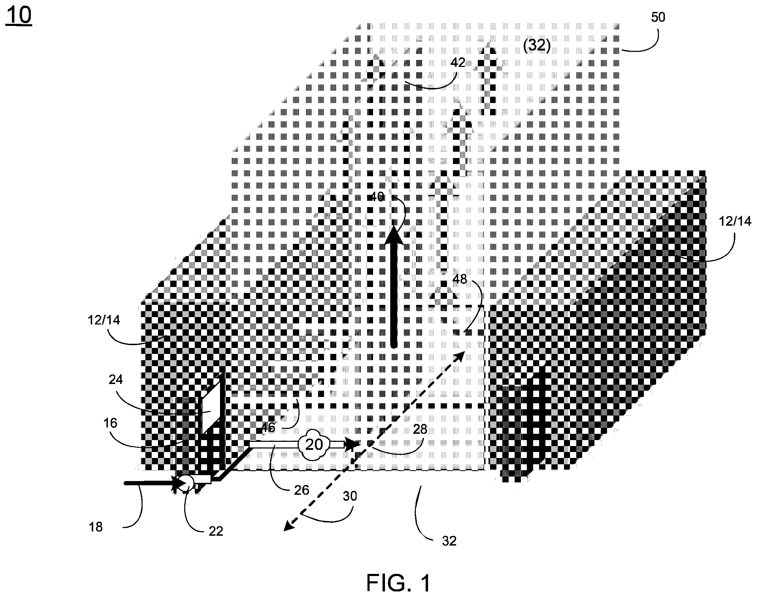

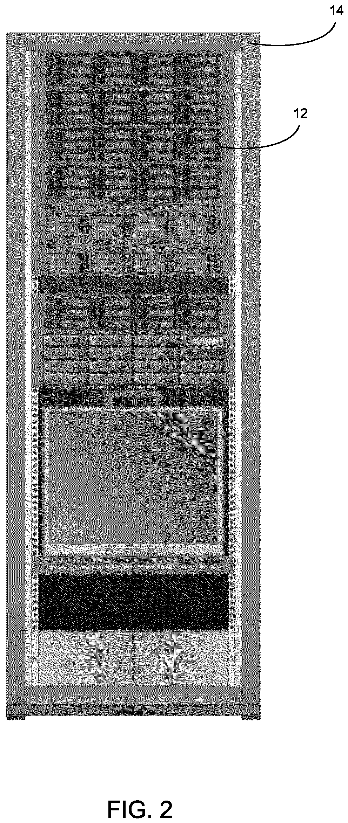

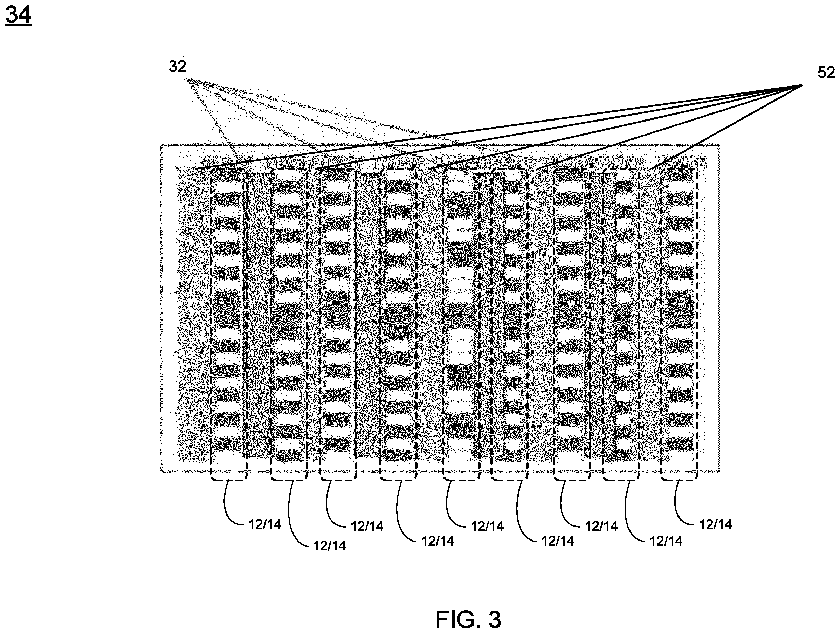

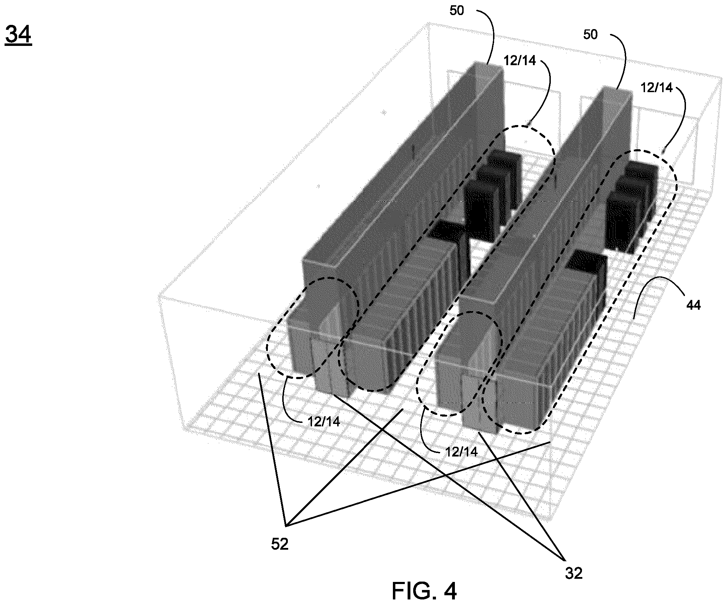

Referring to FIGS. 1-6, there is shown an air-based thermal separation system (e.g., air-based thermal separation system 10) for use proximate rack-mounted IT equipment (e.g., rack-mounted IT equipment 12 within computer rack assembly 14).

The air-based thermal separation system (e.g., air-based thermal separation system 10) may include an air circulation system (e.g., air circulation system 16) configured to receive input air (e.g., input air 18) and generate an output airflow (e.g., output airflow 20). The air circulation system (e.g., air circulation system 16) may also be referred to as a cooling side unit (CSU).

The air circulation system (e.g., air circulation system 16) may include a fan assembly (e.g., fan assembly 22). The fan assembly (e.g., fan assembly 22) may refer to a collection of components designed to create airflow in a particular system or device. These assemblies (e.g., fan assembly 22) are commonly found in various applications, including electronics cooling, HVAC systems, automobiles, and industrial machinery. In electronics cooling, a fan assembly (e.g., fan assembly 22) often consists of a fan blade, motor, housing, and sometimes a grille or shroud, which may be used to dissipate heat generated by electronic components (e.g., computer processors or power supplies) by moving air across heat sinks or other cooling elements. And in HVAC systems, fan assemblies (e.g., fan assembly 22) are integral components that circulate air to maintain target temperatures and ensure adequate ventilation. Such systems may include fan blades, motors, housings, and ductwork.

The air circulation system (e.g., air circulation system 16) may include a mechanical cooling system (e.g., mechanical cooling system 24) for cooling the output airflow (e.g., output airflow 20). A mechanical cooling system (e.g., mechanical cooling system 24) may refer to the equipment and processes used to cool indoor spaces by removing heat from the air. Typically, these systems (e.g., mechanical cooling system 24) consist of several key components. A compressor compresses refrigerant gas, raising its temperature and pressure. This hot, high-pressure gas then flows to the condenser coil, where it dissipates heat to the surroundings and condenses into a liquid. After condensing, the refrigerant passes through an expansion valve, reducing its pressure and causing it to expand and cool down significantly. The cooled refrigerant then flows to the evaporator coil, where it absorbs heat from the indoor air, causing the refrigerant to evaporate back into a gas. A fan assembly (e.g., fan assembly 22) blows air over the evaporator coil, transferring heat from the air to the refrigerant. A duct system (e.g., duct system 26) may distribute the cooled air (e.g., output airflow 20).

The air circulation system (e.g., air circulation system 16) may be configured to be positioned within and/or proximate a computer rack assembly (e.g., computer rack assembly 14). A computer rack assembly (e.g., computer rack assembly 14) is a structured framework designed to efficiently hold and organize computer equipment (e.g., rack-mounted IT equipment 12) in various IT environments such as datacenters and server rooms. Its primary components include a sturdy metal frame providing structural support, horizontal rails for mounting equipment securely, and various mounting hardware like screws and cage nuts for attachment. Some assemblies feature side panels or doors to enclose the equipment, offering security and protection from environmental factors. Cable management features are often integrated to organize and route cables neatly, while ventilation options like perforated doors or built-in fans promote airflow and cooling. Additionally, power distribution units (PDUs) or power strips may be included to facilitate power management for connected equipment. These assemblies come in standard widths of 19 inches, with heights measured in rack units (U). They offer a standardized and efficient solution for organizing and managing IT equipment, catering to the diverse needs of modern computing environments.

The air-based thermal separation system (e.g., air-based thermal separation system 10) may include an air diffuser system (e.g., air diffuser system 28) configured to be longitudinally positioned (e.g., in the direction of arrow 30) within a hot aisle (e.g., hot aisle 32) of a datacenter (e.g., datacenter 34). An air diffuser system (e.g., air diffuser system 28) is a component of HVAC systems, responsible for distributing conditioned air (e.g., output airflow 20). These diffuser systems (e.g., air diffuser system 28) come in various styles and sizes to suit different airflow requirements preferences. The air diffuser system (e.g., air diffuser system 28) may be referred to as a flow rail. The air diffuser system (e.g., air diffuser system 28) may provide feedback (e.g., feedback 35) to the air circulation system (e.g., air circulation system 16) by e.g., monitoring the pressure differential between the pressure of the output airflow (e.g., output airflow 20) and the ambient pressure. Such a configuration may enable the air circulation system (e.g., air circulation system 16) to control such differential pressure by controlling the volume of the output airflow (e.g., output airflow 20) and the quantity of cooling provided to the air diffuser system (e.g., air diffuser system 28), which may be increased / decreased depending upon the quantity of waste heat generated by rack-mounted IT equipment 12. The quantity of air diffuser systems (e.g., air diffuser system 28) may be scaled (upward or downward) depending upon the waste heat generated by rack-mounted IT equipment 12

The air diffuser system (e.g., air diffuser system 28) may include: an input port (e.g., input port 36) for receiving the output airflow (e.g., output airflow 20), and an essentially-linear discharge port (e.g., essentially-linear discharge port 38) for discharging the output airflow (e.g., output airflow 20) in a generally upward direction (i.e., in the direction of arrow 40) to form an essentially-planar discharge airflow (e.g., essentially-planar discharge airflow 42). An example of such an essentially-planar discharge airflow (e.g., essentially-planar discharge airflow 42) may include but is not limited to an air curtain.

An air curtain (e.g., essentially-planar discharge airflow 42), also known as an air door, is a device used in HVAC systems to create a barrier of air. This barrier of air helps to separate two different environments, such as conditioned indoor air and outdoor air, or two differently conditioned indoor spaces, without the need for a physical door. Air curtains typically consist of a fan or blower unit (e.g., fan assembly 22), which generates a high-velocity stream of air (e.g., essentially-planar discharge airflow 42). The airflow (e.g., essentially-planar discharge airflow 42) creates a barrier that prevents the exchange of air between the two spaces.

The air diffuser system (e.g., air diffuser system 28) may be at least as long as the width of a computer rack (e.g., computer rack 14). The average width of a computer rack (e.g., computer rack 14) is standardized at 19 inches (48.26 centimeters). This measurement is a widely adopted industry standard, ensuring compatibility across various brands and types of IT equipment designed for rack mounting. However, while 19 inches is the most common width, wider racks are also available for accommodating larger equipment or for specialized applications. It is also foreseeable that air diffuser system 28 may be many feet long and configured to span multiple computer racks (e.g., computer rack 14).

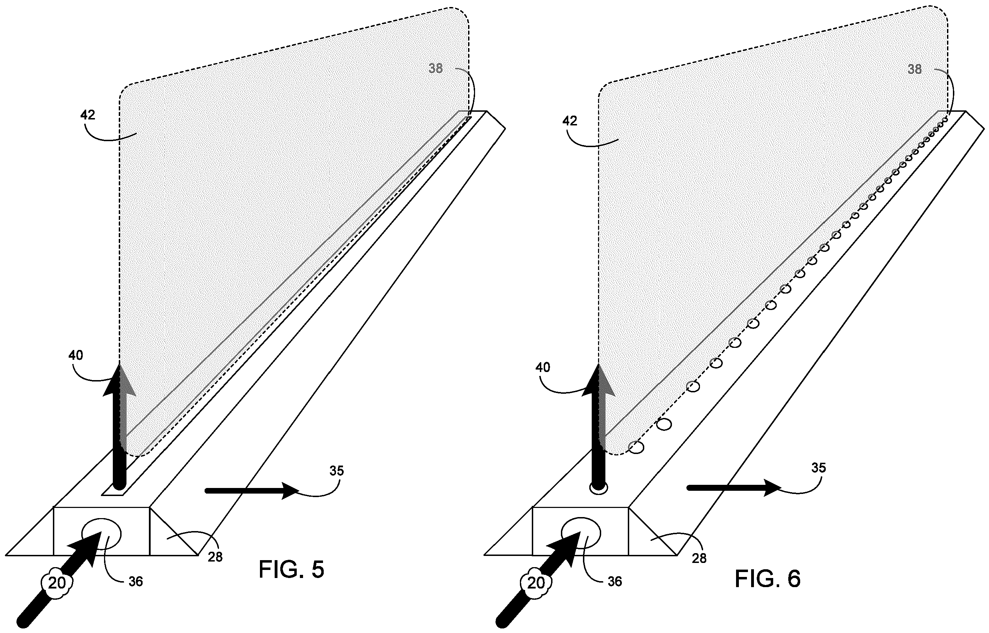

The air diffuser system (e.g., air diffuser system 28) may include one or more discharge slots. For example, essentially-linear discharge port 38 may be / include one or more discharge slots (as shown in FIG. 5).

A discharge slot in an air distribution system refers to a narrow opening or slot through which conditioned air is released into a room or space. These slots are typically located along the length of a linear diffuser (e.g., air diffuser system 28) and are designed to provide a continuous and even distribution of airflow.

The air diffuser system (e.g., air diffuser system 28) may include a plurality of discharge nozzles. For example, essentially-linear discharge port 38 may be / include a plurality of discharge nozzles (as shown in FIG. 6).

In an air distribution system, a discharge nozzle refers to discrete air distribution source. Such discharge nozzles may be arranged in a linear fashion to provide a continuous and even distribution of airflow (in a fashion similar to a discharge slot.

The air diffuser system (e.g., air diffuser system 28) may be configured to be mounted on the floor (e.g., floor 44) of the datacenter (e.g., datacenter 34). In a datacenter, the floor (e.g., floor 44) serves as a crucial component of the overall infrastructure, providing structural support, cable management, airflow distribution, and cooling capabilities. Many datacenters utilize raised flooring systems consisting of removable floor panels supported by a grid of pedestals. This raised floor creates an accessible space beneath where cabling, power distribution, and cooling infrastructure can be routed and organized. Additionally, the raised floor allows for the distribution of cool air from the underfloor plenum to the equipment racks, improving airflow and cooling efficiency.

The air diffuser system (e.g., air diffuser system 28) may be configured to vertically separate the hot aisle (e.g., hot aisle 32) of the datacenter (e.g., datacenter 34) in a longitudinal fashion (e.g., in the direction of arrow 30). Specifically, the air diffuser system (e.g., air diffuser system 28) may be configured to upwardly redirect waste heat (e.g., waste heat 46, 48) from a rack-mounted IT component (e.g., rack-mounted IT equipment 12).

Accordingly and in such a configuration, air-based thermal separation system 10 may prevent the waste heat from higher-power rack-mount IT components exhausting upon (and heating up) lower-power rack mount IT components located across the hot aisle (e.g., hot aisle 32) of datacenter 34, thus thermally isolating opposite sides of the hot aisle of a datacenter (e.g., datacenter 34).

This waste heat (e.g., waste heat 46, 48) from the rack-mounted IT component (e.g., rack-mounted IT equipment 12) may be collected by intake plenum 50, which may direct this waste heat (e.g., waste heat 46, 48) to a cooling system (not shown) for cooling datacenter 34. By collecting such waste heat (e.g., waste heat 46, 48) within intake plenum 50, such waste heat (e.g., waste heat 46, 48) may not infiltrate the cool aisles (e.g., cool aisles 52) of datacenter 34.

The rack-mounted IT component (e.g., rack-mounted IT equipment 12) may include a rack-mounted GPU system. A rack-mounted GPU system may be a configuration where graphics processing units (GPUs) are installed in server racks within a datacenter or server room environment. These systems are designed to harness the parallel processing power of GPUs for various computational tasks, such as high-performance computing (HPC), artificial intelligence (AI), machine learning (ML), deep learning (DL), and scientific simulations.

In a rack-mounted GPU system, multiple GPUs are typically housed within a server chassis or blade enclosure, which is then mounted in a standard server rack alongside other computing and networking equipment. These systems are often used in scenarios where high computational throughput is required, such as in scientific research, financial modeling, data analytics, and rendering for media and entertainment.

Rack-mounted GPU systems offer several advantages:
- **Parallel Processing Power:** GPUs are well-suited for parallel processing tasks due to their many cores and specialized architecture. By leveraging multiple GPUs in a rack-mounted system, organizations can significantly accelerate computational tasks compared to traditional CPU-based systems.
- **Scalability:** Rack-mounted GPU systems can be easily scaled by adding additional GPU-equipped servers to the rack as computing demands increase. This scalability allows organizations to adapt to changing workload requirements without overhauling their infrastructure.
- **Density:** By consolidating multiple GPUs within a single server chassis or blade enclosure, rack-mounted GPU systems offer high compute density, enabling organizations to maximize the utilization of limited datacenter space.
- **Centralized Management:** Rack-mounted GPU systems can be centrally managed and monitored, making it easier for IT administrators to oversee and maintain the computing infrastructure efficiently.

Overall, rack-mounted GPU systems are a powerful solution for organizations seeking high-performance computing capabilities for demanding workloads while optimizing space and resource utilization in their datacenters.

### System Overview:

In an aspect, the technology relates to an air-based thermal separation system for use proximate rack-mounted IT equipment comprising: an air circulation system configured to receive input air and generate an output airflow; and an air diffuser system configured to be longitudinally positioned within a hot aisle of a datacenter, the air diffuser system including: an input port for receiving the output airflow, and an essentially-linear discharge port for discharging the output airflow in a generally upward direction to form an essentially-planar discharge airflow.

In an example, the air circulation system includes a fan assembly.

In an example, the air circulation system includes: a mechanical cooling system for cooling the output airflow.

In an example, the air circulation system is configured to be positioned within a computer rack assembly.

In an example, the air circulation system is configured to be positioned proximate a computer rack assembly.

In an example, the air diffuser system is at least as long as the width of a computer rack.

In an example, the air diffuser system includes: a plurality of discharge nozzles.

In an example, the air diffuser system includes a one or more discharge slots.

In an example, the air diffuser system is configured to be mounted on the floor of the datacenter.

In an example, the air diffuser system is configured to vertically separate the hot aisle of the datacenter in a longitudinal fashion.

In an example, the air diffuser system is configured to upwardly redirect waste heat from a rack-mounted IT component.

In an example, the rack-mounted IT component includes a rack-mounted GPU system.

In an aspect, the technology relates to an air-based thermal separation system for use proximate rack-mounted IT equipment comprising: an air circulation system configured to receive input air and generate an output airflow, the air circulation system including a fan assembly; and an air diffuser system configured to be longitudinally positioned within a hot aisle of a datacenter, the air diffuser system including: an input port for receiving the output airflow, and an essentially-linear discharge port for discharging the output airflow in a generally upward direction to form an essentially-planar discharge airflow; wherein the air diffuser system is configured to be mounted on the floor of the datacenter.

In an example, the air circulation system includes a mechanical cooling system for cooling the output airflow.

In an example, the air diffuser system includes a plurality of discharge nozzles.

In an example, the air diffuser system includes a one or more discharge slots.

In an example, the air diffuser system is configured to vertically separate the hot aisle of the datacenter in a longitudinal fashion.

In an aspect, the technology relates to an air-based thermal separation system for use proximate rack-mounted IT equipment comprising: an air circulation system configured to receive input air and generate an output airflow, the air circulation system including a mechanical cooling system for cooling the output airflow; and an air diffuser system configured to be longitudinally positioned within a hot aisle of a datacenter, the air diffuser system including: an input port for receiving the output airflow, and an essentially-linear discharge port for discharging the output airflow in a generally upward direction to form an essentially-planar discharge airflow; wherein the air diffuser system is configured to be mounted on the floor of the datacenter and vertically separate the hot aisle of the datacenter in a longitudinal fashion.

In an example, the air diffuser system is configured to upwardly redirect waste heat from a rack-mounted IT component.

In an example, the rack-mounted IT component includes a rack-mounted GPU system.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

A number of implementations have been described. Having thus described the disclosure of the present application in detail and by reference to embodiments thereof, it will be apparent that modifications and variations are possible without departing from the scope of the disclosure defined in the appended claims.

## Claims

1. An air-based thermal separation system for use proximate rack-mounted IT equipment comprising:
an air circulation system configured to receive input air and generate an output airflow; and
an air diffuser system configured to be longitudinally positioned within a hot aisle of a datacenter, the air diffuser system including:
an input port for receiving the output airflow, and
an essentially-linear discharge port for discharging the output airflow in a generally upward direction to form an essentially-planar discharge airflow.

2. The air-based thermal separation device of claim 1 wherein the air circulation system includes:
a fan assembly.

3. The air-based thermal separation device of claim 1 or 2 wherein the air circulation system includes:
a mechanical cooling system for cooling the output airflow.

4. The air-based thermal separation device of any of claims 1-3 wherein the air circulation system is configured to be positioned within a computer rack assembly.

5. The air-based thermal separation device of any of claims 1-3 wherein the air circulation system is configured to be positioned proximate a computer rack assembly.

6. The air-based thermal separation device of any of claims 1-3 wherein the air diffuser system is at least as long as the width of a computer rack.

7. The air-based thermal separation device of any of claims 1-6 wherein the air diffuser system includes:
a plurality of discharge nozzles.

8. The air-based thermal separation device of any of claims 1-7 wherein the air diffuser system includes:
a one or more discharge slots.

9. The air-based thermal separation device of any of claims 1-8 wherein the air diffuser system is configured to be mounted on the floor of the datacenter.

10. The air-based thermal separation device of any of claims 1-9 wherein the air diffuser system is configured to vertically separate the hot aisle of the datacenter in a longitudinal fashion.

11. The air-based thermal separation device of any of claims 1-10 wherein the air diffuser system is configured to upwardly redirect waste heat from a rack-mounted IT component.

12. The air-based thermal separation device of claim 11 wherein the rack-mounted IT component includes a rack-mounted GPU system.

13. An air-based thermal separation system for use proximate rack-mounted IT equipment comprising:
an air circulation system configured to receive input air and generate an output airflow, the air circulation system including a fan assembly; and
an air diffuser system configured to be longitudinally positioned within a hot aisle of a datacenter, the air diffuser system including:
an input port for receiving the output airflow, and
an essentially-linear discharge port for discharging the output airflow in a generally upward direction to form an essentially-planar discharge airflow;
wherein the air diffuser system is configured to be mounted on the floor of the datacenter.

14. The air-based thermal separation device of claim 13 wherein the air circulation system includes:
a mechanical cooling system for cooling the output airflow.

15. The air-based thermal separation device of claim 13 or 14 wherein the air diffuser system includes:
a plurality of discharge nozzles.
